# EUROPEAN PATENT SPECIFICATION

(11) **EP 3 770 958 B1**
(45) Date of publication and mention of the grant of the patent: **26.01.2022**
(21) Application number: 18910320.3
(22) Date of filing: 19.03.2018
(51) Int. Cl.: H01L 23/473

(54) **LIQUID-COOLED COOLER**
FLÜSSIGKEITSGEKÜHLTER KÜHLER
REFROIDISSEUR À REFROIDISSEMENT LIQUIDE

(43) Date of publication of application: 27.01.2021
(73) Proprietor: Mitsubishi Electric Corporation, Tokyo 100-8310 (JP)
(72) Inventor: ARATA, Kazuki, Tokyo 100-8310 (JP); NAKAMURA, Takuya, Tokyo 102-0073 (JP); TAMURA, Masayoshi, Tokyo 100-8310 (JP)
(74) Representative: Hoffmann Eitle
(86) International application number: PCT/JP2018/010730
(87) International publication number: WO 2019/180762

(56) References cited:
- JP-A- 2006 295 178
- JP-A- 2008 235 725
- JP-A- 2014 116 404
- JP-A- 2015 153 799

## Description

### TECHNICAL FIELD

The present disclosure relates to a liquid-cooling-type cooler for cooling a heat generating element.

### BACKGROUND ART

Costs for SiC chips of power semiconductors and the like are high, and thus reduction in the chip sizes is essential. As a result, the heat generation density increases and the temperature becomes high. Thus, liquid-cooling-type coolers having higher cooling performance than conventional air-cooling-type coolers are used in many cases.

For example, Patent Document 1 discloses a liquid-cooling-type cooler having a three-layer flow path configuration in which the upper layer and the lower layer have heat dissipation fins disposed therein so as to serve as heat dissipation regions and the middle layer serves as an inlet and an outlet for a coolant. In this conventional example, an inlet header region and an outlet header region separated from each other by a partition wall are formed in a region that is different from the heat dissipation regions, and an inflow port and an outflow port for a cooling liquid can be provided at any locations in the entire outer surface areas of the inlet header region and the outlet header region, respectively.

In addition, Patent Document 2 discloses a cooler in which an introduction port and a discharge port for a coolant are formed in the same wall surface of a water jacket, and which includes: a coolant introduction flow path extending from the introduction port; a coolant discharge flow path disposed parallel to the coolant introduction flow path and extending to the discharge port; and a cooling flow path in which a heat sink is disposed and which is formed at a position that allows communication between the coolant introduction flow path and the coolant discharge flow path. In this conventional example, a guide portion for guiding a coolant toward one side surface of the heat sink is disposed in the coolant introduction flow path, thereby solving uneven flow in which the coolant running into the cooling flow path unevenly flows.

### CITATION LIST

### PATENT DOCUMENT

Patent Document 1: Japanese Laid-Open Patent Publication No. 2015-153799
Patent Document 2: WO2012/147544

### SUMMARY OF THE INVENTION

### PROBLEMS TO BE SOLVED BY THE INVENTION

In the above-described Patent Document 1, since the inlet header region and the outlet header region are provided, the degree of freedom in the locations of disposition of the inflow port and the outflow port for the cooling liquid is increased. However, such a conventional liquid-cooling-type cooler is, in many cases, subject to restrictions on the pipe layout, and the positions of the inflow port and the outflow port for the coolant are fixed in many cases. Therefore, in association with increase in the number of heat generating elements to be disposed, the cooler is enlarged in a coolant advancing direction, thereby ensuring a mounting surface for the heat generating elements. In this case, since the heat generating elements are arrayed in the coolant advancing direction, a problem arises in that the temperature of the coolant directly under the heat generating element disposed on the outflow port side is higher than said temperature on the inflow port side.

In addition, since the distances of the flow paths in the cooler are elongated in association with the enlargement of the cooler, and further, the distance of a passage through a region of the fins as a main factor in pressure loss is elongated, another problem arises in that the pressure loss increases. In addition, if a flow rate adjusting header is provided beside each heat dissipation region and a flow path cross-sectional area is increased, still another problem arises in that the projected area of the cooler increases, and the size of the cooler increases.

In the above-described Patent Document 2, since the coolant introduction flow path and the cooling flow path in which the heat sink is disposed are perpendicular to each other, the distance of passage through the region of the fins is not elongated even if the cooler is enlarged in the coolant advancing direction. However, since the coolant introduction flow path is extended, the effect of the guide portion diminishes, and it becomes difficult to evenly guide the coolant toward the one side surface of the heat sink. In addition, if a region for deflecting the coolant advancing direction is provided at a location other than a heat dissipation region as in this Patent Document 2, the projected area of the cooler increases, and the size increase cannot be avoided.

The present disclosure discloses a technology for solving the above-described problems, and an object of the present disclosure is to provide a liquid-cooling-type cooler which enables suppression of increase in the size of the device and increase in pressure loss caused in association with enlargement of a mounting surface for a heat generating element, and in which a uniform cooling effect is obtained on the mounting surface.

### SOLUTION TO THE PROBLEMS

A liquid-cooling-type cooler according to the present disclosure includes: a heat sink having a first heat dissipation fin; a jacket having a second heat dissipation fin and forming a cooling container together with the heat sink; and a partition member disposed between the first heat dissipation fin and the second heat dissipation fin which are disposed so as to face each other in the cooling container. The cooling container separately has, in a pair of side wall surfaces thereof facing each other, an inflow port and an outflow port for a coolant and has an inlet flow path and an outlet flow path which are disposed parallel to each other along another pair of side wall surfaces, of the cooling container, that face each other. The partition member has: a pair of sheet portions which are respectively in contact with the first heat dissipation fin and the second heat dissipation fin; and a partition wall coupling the pair of sheet portions. Two layers of heat dissipation regions are formed by one of the sheet portions and the first heat dissipation fin, and the other sheet portion and the second heat dissipation fin, respectively. An inlet header region and an outlet header region are formed, between the two layers of heat dissipation regions, by the pair of sheet portions and the partition wall. The inlet header region communicates with the inflow port, the outlet header region communicates with the outflow port, and the two layers of heat dissipation regions communicate with the inlet header region via the inlet flow path and communicate with the outlet header region via the outlet flow path. If, in a plane parallel to a mounting surface for the first heat dissipation fin, an inflow direction of a coolant to the inflow port is defined as a Y direction and a direction perpendicular to the Y direction is defined as an X direction, the partition member guides a coolant, which has flowed in the Y direction into the inlet header region, to the inlet flow path while deflecting an advancing direction of the coolant by the partition wall, and causes the coolant to flow in the X direction from the inlet flow path into the two layers of heat dissipation regions.

### EFFECT OF THE INVENTION

In the liquid-cooling-type cooler according to the present disclosure, the inlet header region and the outlet header region are formed by the partition member disposed between the two layers of heat dissipation regions, and the coolant having flowed in the Y direction from the inflow port into the inlet header region is guided to the inlet flow path while the advancing direction of the coolant is being deflected by the partition wall, whereby the coolant having passed through the header region can be caused to flow into the entire area of the inlet flow path at an approximately equal flow rate and can be caused to further flow in the X direction into the heat dissipation regions at an even flow rate. Accordingly, a uniform cooling effect is obtained on the entire surfaces of the heat dissipation regions. In addition, even if the cooling container is enlarged in the Y direction, the distance for which the coolant passes through each heat dissipation fin is unchanged, and thus increase in the pressure loss can be suppressed. Furthermore, since the inlet header region and the outlet header region are provided between the two layers of heat dissipation regions, increase in the size of the device can be suppressed.

Objects, features, viewpoints, and effects of the present disclosure other than the above-described ones will be more clarified from the following detailed description of the present disclosure with reference to the drawings.

### BRIEF DESCRIPTION OF THE DRAWINGS

[FIG. 1] FIG. 1 is an exploded perspective view for explaining a configuration of a liquid-cooling-type cooler according to embodiment 1.
[FIG. 2] FIG. 2 is a plan view of the liquid-cooling-type cooler according to embodiment 1.
[FIG. 3] FIG. 3 is a cross-sectional perspective view of the liquid-cooling-type cooler according to embodiment 1.
[FIG. 4] FIG. 4 is a partially enlarged cross-sectional perspective view of the liquid-cooling-type cooler according to embodiment 1.
[FIG. 5] FIG. 5 is a diagram for explaining flow of a coolant in the liquid-cooling-type cooler according to embodiment 1.
[FIG. 6] FIG. 6 is a perspective view of a modification of a partition member in the liquid-cooling-type cooler according to embodiment 1.
[FIG. 7] FIG. 7 is a perspective view of another modification of the partition member in the liquid-cooling-type cooler according to embodiment 1.
[FIG. 8] FIG. 8 is an exploded perspective view for explaining a configuration of a liquid-cooling-type cooler according to embodiment 2.
[FIG. 9] FIG. 9 is a plan view of the liquid-cooling-type cooler according to embodiment 2.
[FIG. 10] FIG. 10 is a partially enlarged cross-sectional perspective view of the liquid-cooling-type cooler according to embodiment 2.
[FIG. 11] FIG. 11 is an exploded perspective view for explaining a configuration of a liquid-cooling-type cooler according to embodiment 3.
[FIG. 12] FIG. 12 is a plan view of the liquid-cooling-type cooler according to embodiment 3.
[FIG. 13] FIG. 13 is a cross-sectional view of the liquid-cooling-type cooler according to embodiment 3.
[FIG. 14] FIG. 14 is a cross-sectional view of a liquid-cooling-type cooler according to embodiment 4.
[FIG. 15] FIG. 15 is a plan view of a liquid-cooling-type cooler according to embodiment 5.
[FIG. 16] FIG. 16 is a cross-sectional view of the liquid-cooling-type cooler according to embodiment 5.
[FIG. 17] FIG. 17 is a cross-sectional view of a liquid-cooling-type cooler according to embodiment 6.

### DESCRIPTION OF EMBODIMENTS

### Embodiment 1

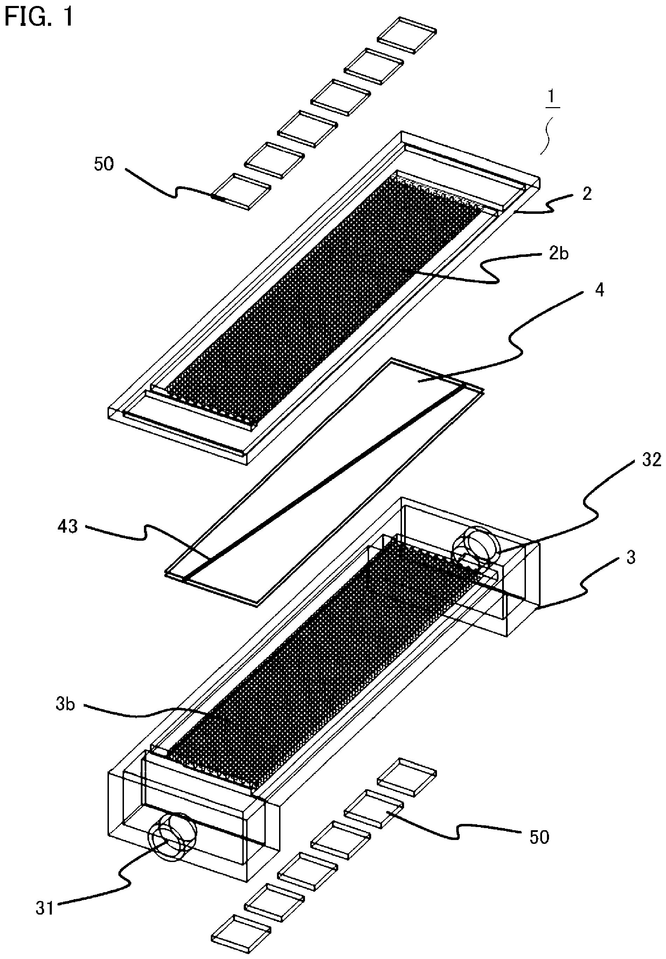

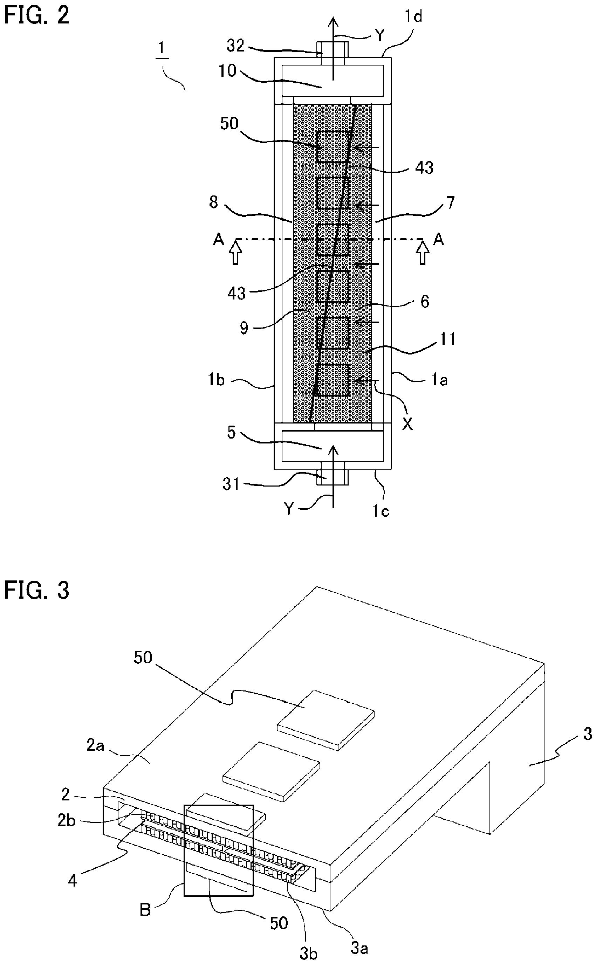

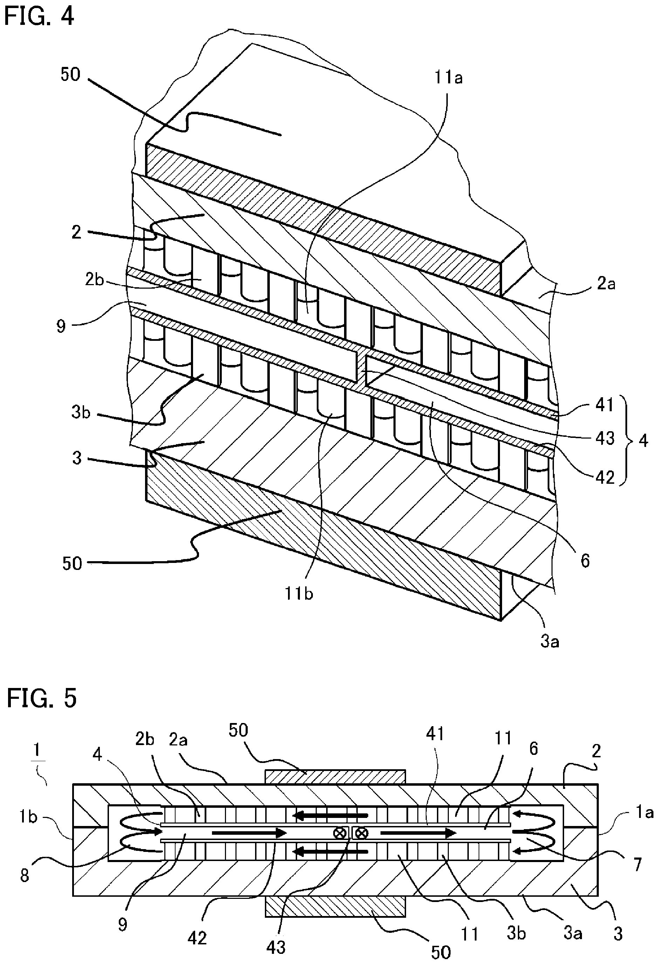

Hereinafter, a liquid-cooling-type cooler according to embodiment 1 will be described with reference to the drawings. FIG. 1 is an exploded perspective view for explaining a configuration of the liquid-cooling-type cooler according to embodiment 1, and components thereof are shown so as to be seen through. FIG. 2 is a plan view of the liquid-cooling-type cooler according to embodiment 1. FIG. 3 is a cross-sectional perspective view in which a cross section taken at the positions indicated by A-A in FIG. 2 is seen in the directions of arrows. FIG. 4 is a cross-sectional perspective view in which a part enclosed by a solid line indicated by "B" in FIG. 3 is enlarged. FIG. 5 is a diagram for explaining flow of a coolant in the liquid-cooling-type cooler according to embodiment 1. In the drawings, identical or corresponding components are denoted by the same reference characters.

As shown in FIG. 1, a liquid-cooling-type cooler 1 according to the present embodiment 1 includes a heat sink 2, a jacket 3, and a partition member 4. The heat sink 2 and the jacket 3 are each formed from, for example, a material that has excellent thermal conductivity such as aluminum or copper. A plurality of heat generating elements 50 are disposed on a base surface 2a of the heat sink 2, and the heat sink 2 has, on a surface thereof at the side opposite to the base surface 2a, heat dissipation fins 2b which are each a first heat dissipation fin.

The jacket 3 forms a cooling container of the liquid-cooling-type cooler 1 together with the heat sink 2. A plurality of heat generating elements 50 are disposed on a base surface 3a of the jacket 3, and the jacket 3 has, on a surface thereof at the side opposite to the base surface 3a, heat dissipation fins 3b which are each a second heat dissipation fin. The heat generating elements 50 are fixed to the base surfaces 2a and 3a by means of metallic bonding, grease, adhesion, or the like.

The partition member 4 is disposed between the heat dissipation fins 2b and 3b which are disposed so as to face each other in the cooling container. The partition member 4 has: a pair of sheet portions 41 and 42 which are respectively in contact with the heat dissipation fins 2b and 3b; and a partition wall 43 coupling the pair of sheet portions 41 and 42. Two layers of heat dissipation regions 11a and 11b (collectively referred to as heat dissipation regions 11) are formed by one of the sheet portions 41 and each heat dissipation fin 2b, and the other sheet portion 42 and each heat dissipation fin 3b, respectively.

In the partition member 4, an inlet header region 6 and an outlet header region 9 are formed between the two layers of heat dissipation regions 11a and 11b by the pair of sheet portions 41 and 42 and the partition wall 43. That is, the partition wall 43 partitions an intermediate layer formed by the pair of sheet portions 41 and 42, into the inlet header region 6 and the outlet header region 9.

As shown in FIG. 2, the cooling container of the liquid-cooling-type cooler 1 has a pair of longitudinal-direction side wall surfaces 1a and 1b facing each other, and a pair of short-side-direction side wall surfaces 1c and 1d perpendicular thereto. The cooling container further separately has, in the short-side-direction side wall surfaces 1c and 1d, an inflow port 31 and an outflow port 32 for a coolant, and has an inlet flow path 7 and an outlet flow path 8 which are disposed parallel to each other along the longitudinal-direction side wall surfaces 1a and 1b. The heat dissipation regions 11 communicate with the inlet header region 6 via the inlet flow path 7 and communicate with the outlet header region 9 via the outlet flow path 8.

On the inner side of the short-side-direction side wall surfaces 1c and 1d, a coolant inlet portion 5 communicating with the inflow port 31 and a coolant outlet portion 10 communicating with the outflow port 32 are provided. The coolant inlet portion 5 communicates with the inlet flow path 7 via the inlet header region 6, and the coolant outlet portion 10 communicates with the outlet flow path 8 via the outlet header region 9. That is, a coolant having flowed in from the inflow port 31 passes through the coolant inlet portion 5, the inlet header region 6, the inlet flow path 7, the heat dissipation regions 11, the outlet flow path 8, the outlet header region 9, and the coolant outlet portion 10 and is discharged from the outflow port 32.

In the following description, in a plane parallel to mounting surfaces for the heat dissipation fins 2b and 3b, the inflow direction of the coolant to the inflow port 31 is defined as a Y direction, and a direction perpendicular to the Y direction is defined as an X direction (see FIG. 2). The plurality of heat generating elements 50 are arrayed in the Y direction which is the longitudinal direction. If the number of the heat generating elements 50 to be disposed increases, the cooling container is enlarged in the Y direction. In each heat dissipation region 11, the arraying direction (Y direction) of the heat generating elements 50 and an advancing direction (X direction) of the coolant are perpendicular to each other.

As shown in FIG. 1 and FIG. 2, when the partition member 4 is seen in a direction perpendicular to surfaces of the sheet portions 41 and 42, the partition wall 43 has a linear shape, and the flow path cross-sectional area of the inlet header region 6 decreases continuously from the inflow port 31 side toward the outflow port 32 side. That is, the flow path cross-sectional area of the inlet header region 6 is smaller on the outflow port 32 side than on the inflow port 31 side. Accordingly, the partition member 4 can guide a coolant, which has flowed in the Y direction into the inlet header region 6, to the inlet flow path 7 while deflecting the advancing direction of the coolant by the partition wall 43, and can cause the coolant to flow in the X direction from the inlet flow path 7 to the two layers of heat dissipation regions 11a and 11b.

The flow of a coolant in the liquid-cooling-type cooler 1 will be described with reference to FIG. 2 and FIG. 5. In FIG. 2 and FIG. 5, arrows indicate the flow of a coolant. A coolant such as cooling water supplied from outside flows in the Y direction from the inflow port 31 into the coolant inlet portion 5, and then flows into the inlet header region 6. In the inlet header region 6, since the flow path cross-sectional area thereof decreases in the Y direction, the advancing direction of the coolant is deflected toward the inlet flow path 7. In the inlet header region 6, the fluid resistances of the coolant flowing on the inflow port 31 side and the coolant flowing on the outflow port 32 side are approximately equal to each other.

Therefore, the flow rate of the coolant having passed through the inlet header region 6 does not decrease even on the outflow port 32 side, and the coolant flows into the entire area of the inlet flow path 7 at an approximately equal flow rate and further flows in the X direction from the inlet flow path 7 to the heat dissipation regions 11a and 11b on the upper layer and the lower layer. At this time, the coolant having flowed into the entire area of the inlet flow path 7 at an approximately equal flow rate evenly flows into one side surface of each heat dissipation region 11. The coolants having flowed into the heat dissipation regions 11a and 11b are subjected to heat exchange with the heat dissipation fins 2b and 3b having absorbed heat from the heat generating elements 50. The coolants having received heat by the heat exchange merge with each other at the outlet flow path 8, and then the coolant passes through the outlet header region 9, flows into the coolant outlet portion 10, and is discharged from the outflow port 32.

The shape of the partition wall when the partition member 4 is seen in the direction perpendicular to the surfaces of the sheet portions 41 and 42, is not limited to linear, and may be zigzag or curved. In addition, the flow path cross-sectional area of the inlet header region 6 may decrease in stages from the inflow port 31 side toward the outflow port 32 side or may decrease while repetitively increasing and decreasing. In either of the cases, the flow path cross-sectional area of the inlet header region 6 is smaller on the outflow port 32 side than on the inflow port 31 side.

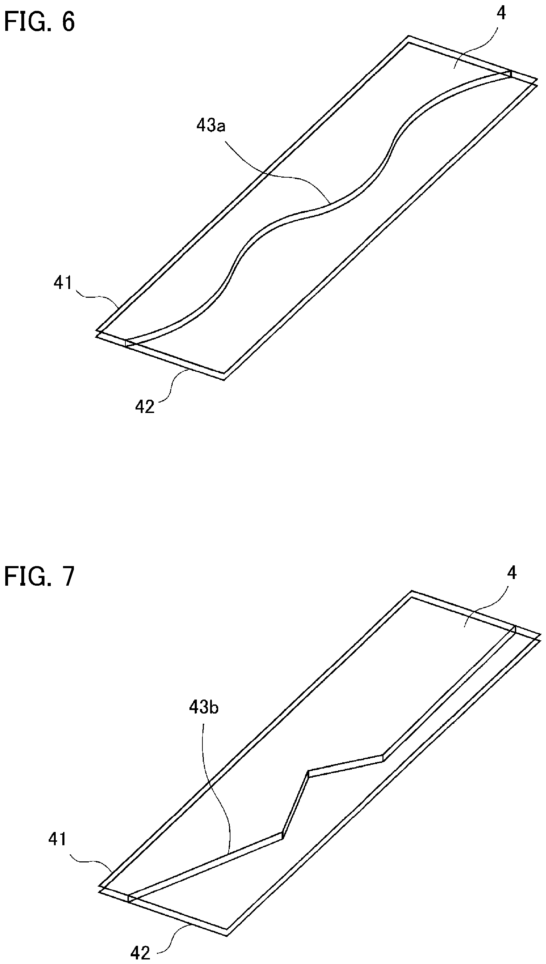

In the case of the linear partition wall 43, the plurality of heat generating elements 50 arrayed in the Y direction are uniformly cooled. Meanwhile, in a case where heat generating elements having different heat generation densities are disposed, the shape of the partition wall can be changed so as to obtain a necessary cooling performance for each heat generating element. For example, a curved partition wall 43a shown in FIG. 6 or a zigzag partition wall 43b shown in FIG. 7 may be formed so that the flow rate of the coolant is controlled so as to increase at a desired location. Specifically, since the fluid resistance increases at a location at which the flow path cross-sectional area of the inlet header region 6 is made small, the flow rate of the coolant flowing into the inlet flow path 7 increases, and the flow rate of the coolant flowing into the heat dissipation regions 11 also increases.

The shape of the partition wall 43a, 43b is preferably determined such that the flow rate of the coolant passing through locations, in each heat dissipation region 11, that correspond to the locations at which the heat generating elements 50 are disposed becomes higher than the flow rate of the coolant passing through locations, in the heat dissipation region 11, that do not correspond to the locations at which the heat generating elements 50 are disposed. Alternatively, the flow rate of the coolant passing through a location, in the heat dissipation region 11, that corresponds to a location at which a heat generating element 50 having a large heat generation density is disposed, can be made particularly high.

According to the present embodiment 1, the inlet header region 6 and the outlet header region 9 are formed by the partition member 4 disposed between the two layers of heat dissipation regions 11a and 11b, and the coolant having flowed in the Y direction from the inflow port 31 into the inlet header region 6 is guided to the inlet flow path 7 while the advancing direction of the coolant is being deflected by the partition wall 43, whereby the coolant having passed through the inlet header region 6 can be caused to flow into the entire area of the inlet flow path 7 at an approximately equal flow rate and can be caused to further flow in the X direction into the one side surface of each heat dissipation region 11 at an even flow rate.

Accordingly, over the entire areas of the base surfaces 2a and 3a on which the heat generating elements 50 are disposed, the coolants having the same temperature can be caused to evenly flow into the heat dissipation regions 11a and 11b directly under the base surfaces 2a and 3a. That is, the coolants having the same temperature can be caused to flow in, directly under the heat generating element 50 close to the inflow port 31 and directly under the heat generating element 50 close to the outflow port 32. Thus, a uniform cooling effect is obtained on the mounting surfaces for the heat generating elements 50.

In addition, even if the cooling container is enlarged in the longitudinal direction (Y direction) in order to enlarge the mounting surfaces for the heat generating elements 50, the distance for which the coolant passes through each of the heat dissipation fins 2b and 3b is unchanged, and thus increase in pressure loss can be suppressed. Furthermore, since the inlet header region 6 and the outlet header region 9 are disposed between the heat dissipation regions 11a and 11b, increase in the projected area of the cooling container can be suppressed. Judging from the above, the liquid-cooling-type cooler 1 according to the present embodiment 1 allows suppression of increase in the size of the device and increase in the pressure loss caused in association with the enlargement of the mounting surfaces for the heat generating elements 50, and allows a uniform cooling effect to be obtained on the mounting surfaces.

### Embodiment 2

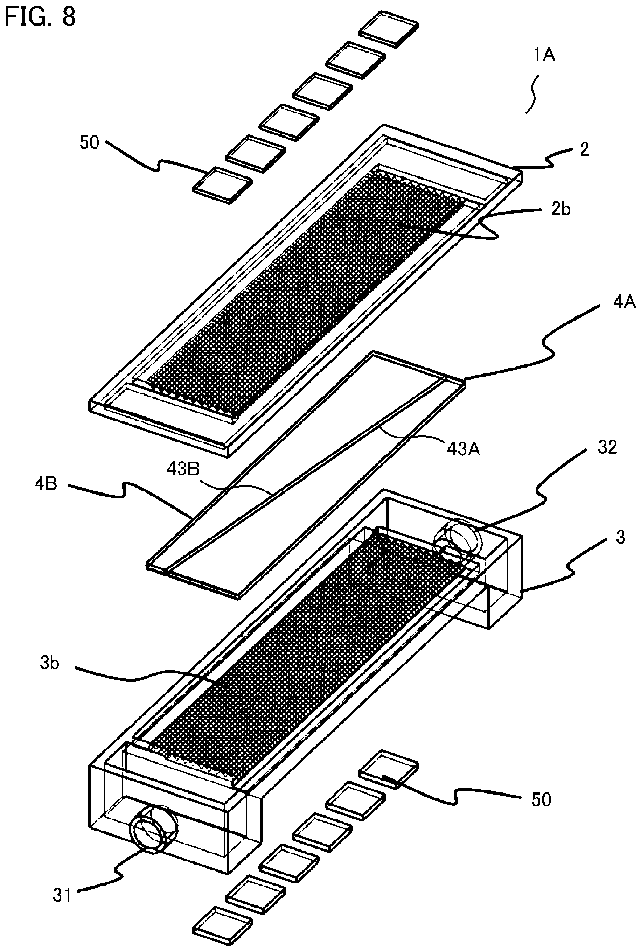

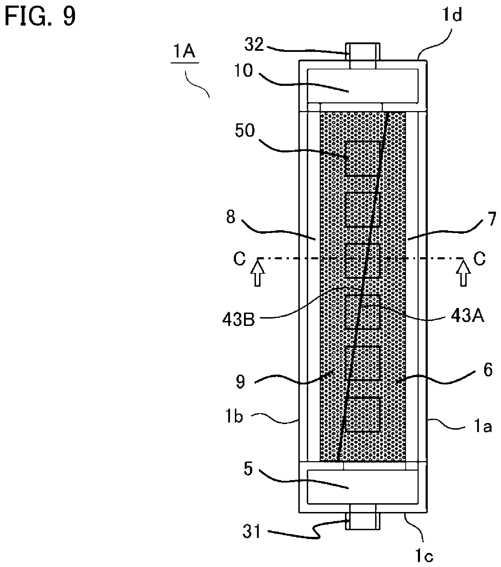

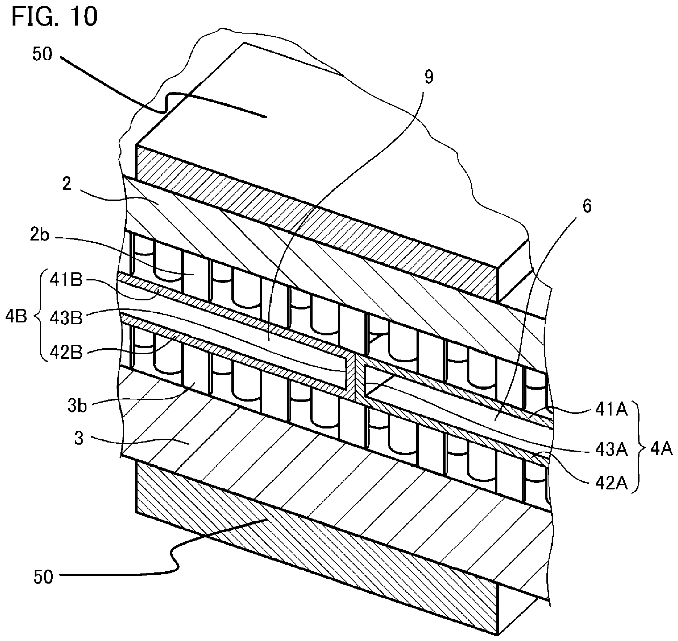

FIG. 8 is an exploded perspective view for explaining a configuration of a liquid-cooling-type cooler according to embodiment 2, and components thereof are shown so as to be seen through. FIG. 9 is a plan view of the liquid-cooling-type cooler according to embodiment 2. FIG. 10 is a cross-sectional perspective view in which a cross section taken at the positions indicated by C-C in FIG. 9 is partially enlarged.

In the above-described embodiment 1, the partition member 4 in which the pair of sheet portions 41 and 42 and the partition wall 43 are integrated with each other is used. However, in a liquid-cooling-type cooler 1A according to the present embodiment 2, the inlet header region 6 and the outlet header region 9 are separately formed by two partition members 4A and 4B. The other components and operations of the liquid-cooling-type cooler 1A according to the present embodiment 2 are the same as those in the above-described embodiment 1, and thus description thereof will be omitted here.

Each of the partition members 4A and 4B according to the present embodiment 2 as seen in the direction from the inflow port 31 or the outflow port 32, has a U-shaped cross section. As shown in FIG. 10, the partition member 4A has: a pair of sheet portions 41A and 42A; and a partition wall 43A coupling the sheet portions 41A and 42A. Similarly, the partition member 4B has: a pair of sheet portions 41B and 42B; and a partition wall 43B coupling the sheet portions 41B and 42B. The partition members 4A and 4B are disposed such that the partition walls 43A and 43B thereof are in contact with each other, between the heat dissipation fins 2b and 3b.

According to the present embodiment 2, since the partition members 4A and 4B having U-shaped cross sections can be each produced from one sheet through drawing process, facilitation of the production and cost reduction are achieved in addition to the same effect as that in the above-described embodiment 1.

### Embodiment 3

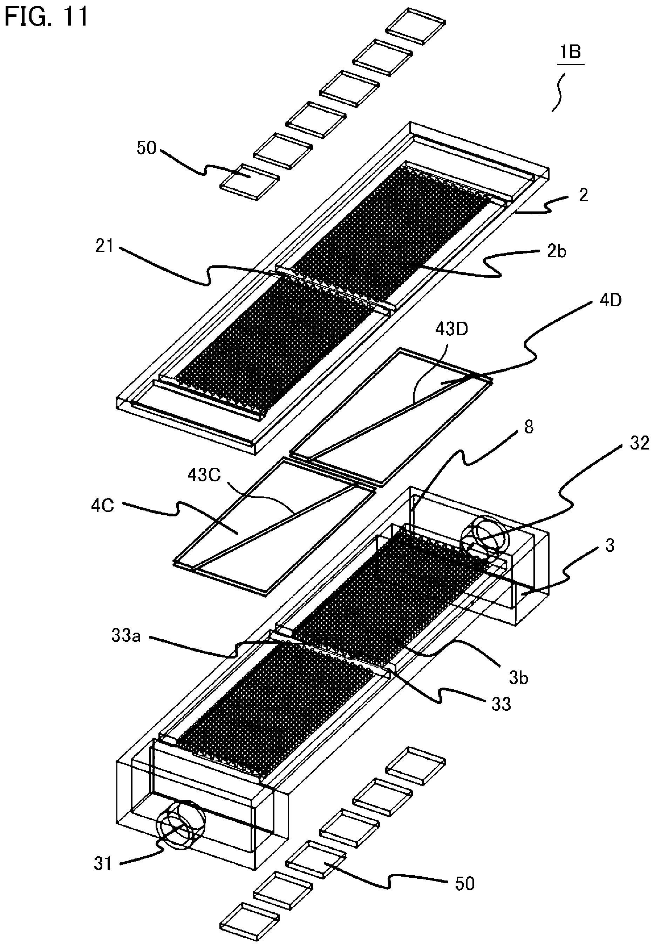

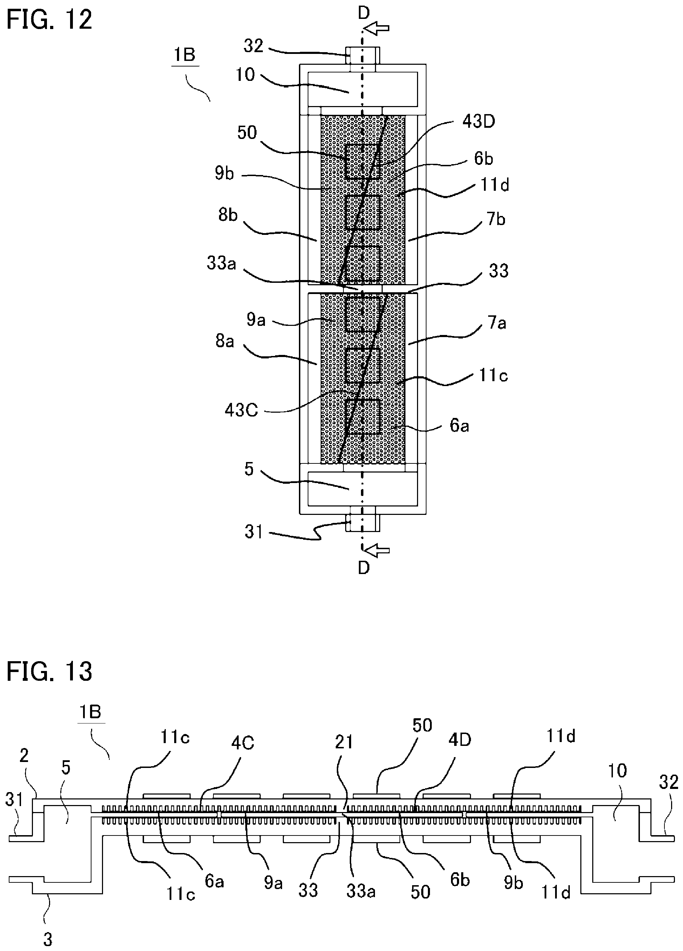

FIG. 11 is an exploded perspective view for explaining a configuration of a liquid-cooling-type cooler according to embodiment 3, and components thereof are shown so as to be seen through. FIG. 12 is a plan view of the liquid-cooling-type cooler according to embodiment 3, and FIG. 13 is a cross-sectional view in which a cross section taken at the positions indicated by D-D in FIG. 12 is seen in the directions of arrows.

A liquid-cooling-type cooler 1B according to the present embodiment 3 includes a heat sink partition sheet 21 and a jacket partition sheet 33 as partition sheets for partitioning the inside of the cooling container into a plurality of zones that are adjacent to each other in the Y direction. Each of the separated zones has the inlet header region, the inlet flow path, the heat dissipation regions, the outlet flow path, and the outlet header region.

Specifically, the heat sink partition sheet 21 partitions the heat dissipation region on the heat sink 2 side into a first heat dissipation region 11c and a second heat dissipation region 11d. The jacket partition sheet 33 partitions the heat dissipation region on the jacket 3 side into a first heat dissipation region 11c and a second heat dissipation region 11d, partitions the inlet flow path into a first inlet flow path 7a and a second inlet flow path 7b, and partitions the outlet flow path into a first outlet flow path 8a and a second outlet flow path 8b.

Accordingly, as shown in FIG. 12, the zone that is closer to the inflow port 31 has the first heat dissipation regions 11c, the first inlet flow path 7a, and the first outlet flow path 8a, and an inlet header region 6a and an outlet header region 9a are formed by a partition member 4C having a partition wall 43C. Meanwhile, the zone that is farther from the inflow port 31 has the second heat dissipation regions 11d, the second inlet flow path 7b, and the second outlet flow path 8b, and an inlet header region 6b and an outlet header region 9b are formed by a partition member 4D having a partition wall 43D.

In addition, the jacket partition sheet 33 has an opening 33a that allows communication between: the outlet header region 9a in the zone that is closer to the inflow port 31, between the two zones that are adjacent to each other; and the inlet header region 6b in the zone that is farther from the inflow port 31, between the two zones.

The flow of a coolant in the liquid-cooling-type cooler 1B is basically the same as that in the above-described embodiment 1. However, after a coolant passes from the first heat dissipation regions 11c through the outlet header region 9a, the coolant passes through the opening 33a of the jacket partition sheet 33 and flows into the inlet header region 6b in the adjacent zone. Then, the coolant passes through the second inlet flow path 7b, the second heat dissipation regions 11d, the second outlet flow path 8b, and the coolant outlet portion 10, and is discharged from the outflow port 32.

Although the inside of the cooling container is partitioned into the two zones that are adjacent to each other in the Y direction in the present embodiment 3, said inside can be partitioned into three or more zones. According to the present embodiment 3, even if the dimension in the longitudinal direction (Y direction) of the cooling container is increased, decrease in the flow rate of the coolant flowing into each zone is suppressed, and thus high cooling performance can be ensured in addition to the same effect as that in the above-described embodiment 1.

### Embodiment 4

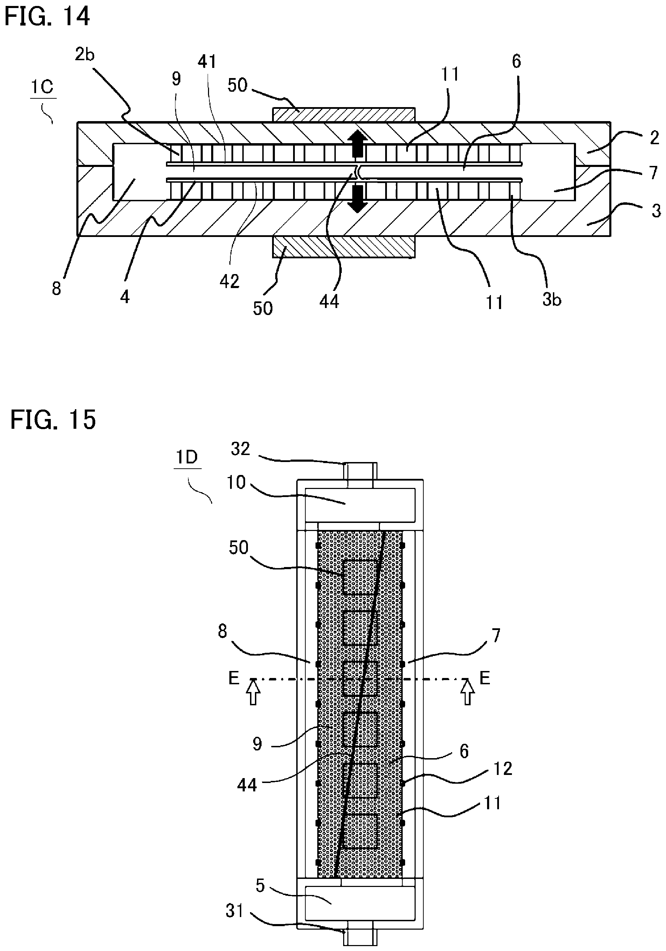

FIG. 14 is a cross-sectional view of a liquid-cooling-type cooler according to embodiment 4. In a liquid-cooling-type cooler 1C according to the present embodiment 4, a partition wall 44 of the partition member 4 is implemented by an elastic member that has elasticity in the direction perpendicular to the surfaces of the sheet portions 41 and 42. The other components and operations of the liquid-cooling-type cooler 1C according to the present embodiment 4 are the same as those in the above-described embodiment 1, and thus description thereof will be omitted here.

In the present embodiment 4, the dimension, in the direction perpendicular to the surfaces of the sheet portions 41 and 42, of the partition member 4 not having yet been assembled to the cooling container is larger than the dimension of a gap between an end of the heat dissipation fin 2b and an end of the heat dissipation fin 3b. Therefore, as shown in FIG. 14, the partition wall 44 is bent owing to load generated when the jacket 3 is closed by the heat sink 2. Furthermore, the sheet portions 41 and 42 are pressed against the heat dissipation fins 2b and 3b in the directions of arrows in FIG. 14 by resilience of the partition wall 44, whereby the sheet portions 41 and 42 are disposed so as to be in close contact with the heat dissipation fins 2b and 3b.

According to the present embodiment 4, since there is no gap between the sheet portion 41, 42 and the heat dissipation fin 2b, 3b, the coolant passing through each heat dissipation region 11 can be assuredly subjected to heat exchange with the heat dissipation fin 2b, 3b, and thus high cooling performance can be ensured in addition to the same effect as that in the above-described embodiment 1.

### Embodiment 5

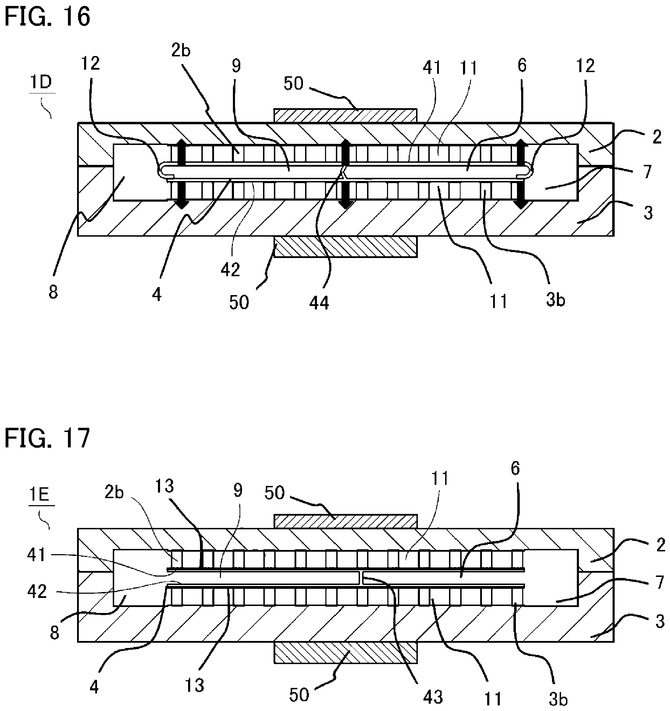

FIG. 15 is a plan view of a liquid-cooling-type cooler according to embodiment 5, and FIG. 16 is a cross-sectional view in which a cross section taken at the positions indicated by E-E in FIG. 15 is seen in the directions of arrows. A liquid-cooling-type cooler 1D according to the present embodiment 5 includes, as in the above-described embodiment 4, the partition member 4 having the partition wall 44 implemented by an elastic member. The liquid-cooling-type cooler 1D further includes, between the pair of sheet portions 41 and 42, a plurality of flat springs 12 supporting outer periphery portions of the sheet portions 41 and 42. The other components and operations of the liquid-cooling-type cooler 1D according to the present embodiment 5 are the same as those in the above-described embodiment 1, and thus description thereof will be omitted here.

In the above-described embodiment 4, the ends of the sheet portions 41 and 42 of the partition member 4 are free ends with the partition wall 44 serving as a supporting point. Therefore, the flow path cross-sectional areas of the inlet header region 6 and the outlet header region 9 may be unstable. In view of this, in the present embodiment 5, the outer periphery portions of the sheet portions 41 and 42 are supported by the flat springs 12 so that desired flow path cross-sectional areas can be more stably maintained than in the above-described embodiment 4. In addition, the sheet portions 41 and 42 are pressed against the heat dissipation fins 2b and 3b in the directions of arrows in FIG. 16 by the elastic force of each flat spring 12, whereby the sheet portions 41 and 42 are disposed so as to be in close contact with the heat dissipation fins 2b and 3b.

According to the present embodiment 5, since the flow path cross-sectional areas of the inlet header region 6 and the outlet header region 9 are ensured by the flat springs 12, a stable cooling effect is obtained and reliability is improved in addition to the same effect as that in the above-described embodiment 4.

### Embodiment 6

FIG. 17 is a cross-sectional view of a liquid-cooling-type cooler according to embodiment 6. In a liquid-cooling-type cooler 1E according to the present embodiment 6, resin materials 13 each having a lower thermal conductivity than the sheet portions 41 and 42 are joined or adhered to surfaces, of the pair of sheet portions 41 and 42 of the partition member 4, that are in contact with the heat dissipation fins 2b and 3b. The other components and operations of the liquid-cooling-type cooler 1E according to the present embodiment 6 are the same as those in the above-described embodiment 1, and thus description thereof will be omitted here.

In the present embodiment 6, since the resin materials 13 each having a lower thermal conductivity than the sheet portions 41 and 42 are provided to the surfaces, of the sheet portions 41 and 42, that are in contact with the heat dissipation fins 2b and 3b, heat from the heat dissipation fins 2b and 3b is inhibited from being conducted via the sheet portions 41 and 42 to the inlet header region 6. Accordingly, increase in the temperature of the coolant passing through the inlet header region 6 can be suppressed, and the temperature of the coolant flowing into the heat dissipation regions 11 can be kept low.

According to the present embodiment 6, since heat can be inhibited from being conducted from the heat dissipation fins 2b and 3b to the inlet header region 6, even higher cooling performance can be ensured in addition to the same effect as that in the above-described embodiment 1.

Although the disclosure is described above in terms of various exemplary embodiments, it should be understood that the various features, aspects and functionality described in one or more of the individual embodiments are not limited in their applicability to the particular embodiment with which they are described, but instead can be applied, alone or in various combinations to one or more of the embodiments of the disclosure. It is therefore understood that numerous modifications which have not been exemplified can be devised without departing from the scope of the specification of the present disclosure. For example, at least one of the constituent components may be modified, added, or eliminated. At least one of the constituent components mentioned in at least one of the preferred embodiments may be selected and combined with the constituent components mentioned in another preferred embodiment.

### DESCRIPTION OF THE REFERENCE CHARACTERS

- 1, 1A, 1B, 1C, 1D, 1E: liquid-cooling-type cooler
- 1a, 1b: longitudinal-direction side wall surface
- 1c, 1d: short-side-direction side wall surface
- 2: heat sink
- 2a: base surface
- 2b: heat dissipation fin
- 3: jacket
- 3a: base surface
- 3b: heat dissipation fin
- 4, 4A, 4B, 4C, 4D: partition member
- 5: coolant inlet portion
- 6, 6a, 6b: inlet header region
- 7: inlet flow path
- 7a: first inlet flow path
- 7b: second inlet flow path
- 8: outlet flow path
- 8a: first outlet flow path
- 8b: second outlet flow path
- 9, 9a, 9b: outlet header region
- 10: coolant outlet portion
- 11, 11a, 11b: heat dissipation region
- 11c: first heat dissipation region
- 11d: second heat dissipation region
- 12: flat spring
- 13: resin material
- 21: heat sink partition sheet
- 31: inflow port
- 32: outflow port
- 33: jacket partition sheet
- 33a: opening
- 41, 41A, 41B, 42, 42A, 42B: sheet portion
- 43, 43a, 43b, 43A, 43B, 43C, 43D, 44: partition wall
- 50: heat generating element

## Claims

1. A liquid-cooling-type cooler comprising:
a heat sink (2) having a first heat dissipation fin (2b) ;
a jacket (3) having a second heat dissipation fin (3b) and forming a cooling container together with the heat sink (2); and
a partition member (4, 4A, 4B, 4C, 4D) disposed between the first heat dissipation fin (2b) and the second heat dissipation fin (3b) which are disposed so as to face each other in the cooling container, wherein
the cooling container separately has, in a pair of side wall surfaces (1c, 1d) thereof facing each other, an inflow port (31) and an outflow port (32) for a coolant and has an inlet flow path (7, 7a, 7b) and an outlet flow path (8, 8a, 8b) which are disposed parallel to each other along another pair of side wall surfaces (1a, 1b), of the cooling container, that face each other,
the partition member (4, 4A, 4B, 4C, 4D) has
a pair of sheet portions (41, 41A, 41B, 42, 42A, 42B) which are respectively in contact with the first heat dissipation fin (2b) and the second heat dissipation fin (3b), and
a partition wall (43, 43a, 43b, 43A, 43B, 43C, 43D, 44) coupling the pair of sheet portions (41, 41A, 41B, 42, 42A, 42B),
two layers of heat dissipation regions (11, 11a, 11b, 11c, 11d) are formed by one of the sheet portions (41, 41A, 41B) and the first heat dissipation fin (2b), and the other sheet portion (42, 42A, 42B) and the second heat dissipation fin (3b), respectively,
an inlet header region (6, 6a, 6b) and an outlet header region (9, 9a, 9b) are formed, between the two layers of heat dissipation regions (11, 11a, 11b, 11c, 11d), by the pair of sheet portions (41, 41A, 41B, 42, 42A, 42B) and the partition wall (43, 43a, 43b, 43A, 43B, 43C, 43D, 44),
the inlet header region (6, 6a, 6b) communicates with the inflow port (31), the outlet header region (9, 9a, 9b) communicates with the outflow port (32), and the two layers of heat dissipation regions (11, 11a, 11b, 11c, 11d) communicate with the inlet header region (6, 6a, 6b) via the inlet flow path (7, 7a, 7b) and communicate with the outlet header region (9, 9a, 9b) via the outlet flow path (8, 8a, 8b), and
if, in a plane parallel to a mounting surface for the first heat dissipation fin (2b), an inflow direction of a coolant to the inflow port (31) is defined as a Y direction and a direction perpendicular to the Y direction is defined as an X direction, the partition member (4, 4A, 4B, 4C, 4D) guides a coolant, which has flowed in the Y direction into the inlet header region (6, 6a, 6b), to the inlet flow path (7, 7a, 7b) while deflecting an advancing direction of the coolant by the partition wall (43, 43a, 43b, 43A, 43B, 43C, 43D, 44), and causes the coolant to flow in the X direction from the inlet flow path (7, 7a, 7b) into the two layers of heat dissipation regions (11, 11a, 11b, 11c, 11d).

2. The liquid-cooling-type cooler according to claim 1, wherein, when the partition member (4, 4A, 4B, 4C, 4D) is seen in a direction perpendicular to surfaces of the sheet portions (41, 41A, 41B, 42, 42A, 42B), a shape of the partition wall (43, 43a, 43b, 43A, 43B, 43C, 43D, 44) is linear, zigzag, or curved.

3. The liquid-cooling-type cooler according to claim 2, wherein a flow path cross-sectional area of the inlet header region (6, 6a, 6b) decreases continuously or in stages from the inflow port (31) side toward the outflow port (32) side.

4. The liquid-cooling-type cooler according to claim 2 or 3, wherein
a surface, of the heat sink (2), at a side opposite to the first heat dissipation fin (2b) and a surface, of the jacket (3), at a side opposite to the second heat dissipation fin (3b) are mounting surfaces on which a plurality of heat generating elements (50) are arrayed in the Y direction, and
the shape of the partition wall (43a, 43b) is determined such that a flow rate of a coolant passing through locations, in each heat dissipation region (11, 11a, 11b, 11c, 11d), that correspond to locations at which the heat generating elements (50) are disposed becomes higher than a flow rate of a coolant passing through locations, in the heat dissipation region (11, 11a, 11b, 11c, 11d), that do not correspond to the locations at which the heat generating elements (50) are disposed.

5. The liquid-cooling-type cooler according to any one of claims 1 to 4, wherein
the partition member (4A, 4B) includes two members each having a U-shaped cross section, and
the inlet header region (6) and the outlet header region (9) are separately formed by the two members.

6. The liquid-cooling-type cooler according to any one of claims 1 to 5, the liquid-cooling-type cooler further comprising partition sheets (21, 33) for partitioning an inside of the cooling container into a plurality of zones that are adjacent to each other in the Y direction, wherein
each of the zones has the inlet header region (6a, 6b), the inlet flow path (7a, 7b), the heat dissipation regions (11c, 11d), the outlet flow path (8a, 8b), and the outlet header region (9a, 9b), and
the partition sheet (33) has an opening (33a) that allows communication between: the outlet header region (9a) in a zone that is closer to the inflow port (31), between two of the zones that are adjacent to each other; and the inlet header region (6b) in a zone that is farther from the inflow port (31), between the two zones.

7. The liquid-cooling-type cooler according to any one of claims 1 to 6, wherein
in the partition member (4), the partition wall (44) is an elastic member that has elasticity in the direction perpendicular to the surfaces of the sheet portions (41, 42), and
the pair of sheet portions (41, 42) are disposed so as to be in close contact with the first heat dissipation fin (2b) and the second heat dissipation fin (3b).

8. The liquid-cooling-type cooler according to claim 7, the liquid-cooling-type cooler further comprising, between the pair of sheet portions (41, 42), a plurality of flat springs (12) which support outer periphery portions of the sheet portions (41, 42).

9. The liquid-cooling-type cooler according to any one of claims 1 to 8, wherein, in the partition member (4), resin materials (13) each having a lower thermal conductivity than the pair of sheet portions (41, 42) are joined or adhered to surfaces, of the sheet portions (41, 42), that are in contact with the first heat dissipation fin (2b) and the second heat dissipation fin (3b).

## Patentansprüche

1. Kühler mit Flüssigkeitskühlung, der Folgendes aufweist:
einen Kühlkörper (2) mit einer ersten Wärmeübertragungsrippe (2b);
einen Mantel (3), der eine zweite Wärmeübertragungsrippe (3b) aufweist und zusammen mit dem Kühlkörper (2) einen Kühlbehälter ausbildet; und
ein Trennelement (4, 4A, 4B, 4C, 4D), das zwischen der ersten Wärmeübertragungsrippe (2b) und der zweiten Wärmeübertragungsrippe (3b) angeordnet ist, die so angeordnet sind, dass sie sich in dem Kühlbehälter gegenüberliegen, wobei
der Kühlbehälter separat in einem Paar von Seitenwandflächen (1c, 1d), die einander zugewandt sind, eine Einlassöffnung (31) und eine Abfließöffnung (32) für ein Kühlmittel aufweist und einen Einlassströmungskanal (7, 7a, 7b) und einen Auslassströmungskanal (8, 8a, 8b) hat, die parallel zueinander entlang eines anderen Paares von Seitenwandflächen (1a, 1b) des Kühlbehälters angeordnet sind, die einander zugewandt sind,
das Trennelement (4, 4A, 4B, 4C, 4D)
ein Paar von Blattabschnitten (41, 41A, 41B, 42, 42A, 42B) aufweist, die jeweils in Kontakt mit der ersten Wärmeübertragungsrippe (2b) und der zweiten Wärmeübertragungsrippe (3b) stehen, und
eine Trennwand (43, 43a, 43b, 43A, 43B, 43C, 43D, 44) aufweist, die das Paar von Blattabschnitten (41, 41A, 41B, 42, 42A, 42B) verbindet,
zwei Schichten von Wärmeübertragungsbereichen (11, 11a, 11b, 11c, 11d) durch einen der Blattabschnitte (41, 41A, 41B) und die erste Wärmeübertragungsrippe (2b) bzw. den anderen Blattabschnitt (42, 42A, 42B) und die zweite Wärmeübertragungsrippe (3b) ausgebildet sind,
wobei ein Einlasssammelbereich (6, 6a, 6b) und ein Auslasssammelbereich (9, 9a, 9b) zwischen den beiden Schichten von Wärmeübertragungsbereichen (11, 11a, 11b, 11c, 11d) durch das Paar von Blattabschnitten (41, 41A, 41B, 42, 42A, 42B) und die Trennwand (43, 43a, 43b, 43A, 43B, 43C, 43D, 44) ausgebildet sind,
der Einlasssammelbereich (6, 6a, 6b) mit der Einlassöffnung (31) in Verbindung steht, der Auslasssammelbereich (9, 9a, 9b) mit der Abfließöffnung (32) in Verbindung steht, und die beiden Schichten von Wärmeübertragungsbereichen (11, 11a, 11b, 11c, 11d) mit dem Einlasssammelbereich (6, 6a, 6b) über den Einlassströmungskanal (7, 7a, 7b) und mit dem Auslasssammelbereich (9, 9a, 9b) über den Auslassströmungskanal (8, 8a, 8b) in Verbindung stehen, und
wenn in einer Ebene parallel zu einer Montagefläche für die erste Wärmeübertragungsrippe (2b) eine Einströmrichtung eines Kühlmittels zu der Einlassöffnung (31) als eine Y-Richtung definiert ist und eine Richtung senkrecht zu der Y-Richtung als eine X-Richtung definiert ist, das Trennelement (4, 4A, 4B, 4C, 4D) ein Kühlmittel, das in der Y-Richtung in den Einlasssammelbereich (6, 6a, 6b) geströmt ist, zu dem Einlassströmungskanal (7, 7a, 7b) leitet, während es eine Vorschubrichtung des Kühlmittels durch die Trennwand (43, 43a, 43b, 43A, 43B, 43C, 43D, 44) ablenkt, und bewirkt, dass das Kühlmittel in der X-Richtung von dem Einlassströmungskanal (7, 7a, 7b) in die zwei Schichten von Wärmeübertragungsbereichen (11, 11a, 11b, 11c, 11d) strömt.

2. Kühler mit Flüssigkeitskühlung nach Anspruch 1, wobei dann, wenn das Trennelement (4, 4A, 4B, 4C, 4D) in einer Richtung senkrecht zu den Oberflächen der Blattabschnitte (41, 41A, 41B, 42, 42A, 42B) gesehen wird, eine Form der Trennwand (43, 43a, 43b, 43A, 43B, 43C, 43D, 44) linear, zickzackförmig oder gekrümmt ist.

3. Kühler mit Flüssigkeitskühlung nach Anspruch 2, wobei eine Strömungskanal-Querschnittsfläche des Einlasssammelbereichs (6, 6a, 6b) von der Seite der Einlassöffnung (31) zur Seite der Abfließöffnung (32) hin kontinuierlich oder stufenweise abnimmt.

4. Kühler mit Flüssigkeitskühlung nach Anspruch 2 oder 3, wobei
eine Oberfläche des Kühlkörpers (2) an einer der ersten Wärmeübertragungsrippe (2b) gegenüberliegenden Seite und eine Oberfläche des Mantels (3) an einer der zweiten Wärmeübertragungsrippe (3b) gegenüberliegenden Seite Montageflächen sind, auf denen eine Vielzahl von Wärmeerzeugungselementen (50) in Y-Richtung aufgereiht sind, und
die Form der Trennwand (43a, 43b) so ausgebildet ist, dass ein Volumenstrom eines Kühlmittels, der durch Stellen in jedem Wärmeübertragungsbereich (11, 11a, 11b, 11c, 11d) fließt, die Stellen entsprechen, an denen die Wärmeerzeugungselemente (50) angeordnet sind, größer wird als ein Volumenstrom eines Kühlmittels, der durch Stellen in dem Wärmeübertragungsbereich (11, 11a, 11b, 11c, 11d) fließt, die nicht den Stellen entsprechen, an denen die Wärmeerzeugungselemente (50) angeordnet sind.

5. Kühler mit Flüssigkeitskühlung nach einem der Ansprüche 1 bis 4, wobei
das Trennelement (4A, 4B) zwei Elemente aufweist, die jeweils einen U-förmigen Querschnitt haben, und
der Einlasssammelbereich (6) und der Auslasssammelbereich (9) getrennt durch die beiden Elemente ausgebildet sind.

6. Kühler mit Flüssigkeitskühlung nach einem der Ansprüche 1 bis 5, wobei der Kühler mit Flüssigkeitskühlung ferner Trennblätter (21, 33) zur Unterteilung eines Innenraums des Kühlbehälters in eine Vielzahl von Zonen aufweist, die in Y-Richtung nebeneinander liegen, wobei
jede der Zonen den Einlasssammelbereich (6a, 6b), den Einlassströmungskanal (7a, 7b), die Wärmeübertragungsbereiche (11c, 11d), den Auslassströmungskanal (8a, 8b) und den Auslasssammelbereich (9a, 9b) aufweist, und
das Trennblatt (33) eine Öffnung (33a) aufweist, die eine Verbindung ermöglicht zwischen: dem Auslasssammelbereich (9a) in einer Zone, die näher an der Einlassöffnung (31) liegt, zwischen zwei der Zonen, die nebeneinander liegen; und dem Einlasssammelbereich (6b) in einer Zone, die weiter von der Einlassöffnung (31) entfernt ist, zwischen den beiden Zonen.

7. Kühler mit Flüssigkeitskühlung nach einem der Ansprüche 1 bis 6, wobei
in dem Trennelement (4) die Trennwand (44) ein elastisches Element ist, das in der Richtung senkrecht zu den Oberflächen der Blattabschnitte (41, 42) elastisch ist, und
das Paar von Blattabschnitten (41, 42) so angeordnet ist, dass es in engem Kontakt mit der ersten Wärmeübertragungsrippe (2b) und der zweiten Wärmeübertragungsrippe (3b) steht.

8. Kühler mit Flüssigkeitskühlung nach Anspruch 7, wobei der Kühler mit Flüssigkeitskühlung ferner zwischen dem Paar von Blattabschnitten (41, 42) eine Vielzahl von Flachfedern (12) aufweist, welche die äußeren Umfangsabschnitte der Blattabschnitte (41, 42) stützen.

9. Kühler mit Flüssigkeitskühlung nach einem der Ansprüche 1 bis 8, wobei in dem Trennelement (4) Harzmaterialien (13), die jeweils eine geringere Wärmeleitfähigkeit als das Paar von Blattabschnitten (41, 42) aufweisen, mit Oberflächen der Blattabschnitte (41, 42), die mit der ersten Wärmeübertragungsrippe (2b) und der zweiten Wärmeübertragungsrippe (3b) in Kontakt sind, verbunden sind oder daran haften.

## Revendications

1. Refroidisseur de type à refroidissement par liquide comprenant :
un dissipateur thermique (2) présentant une première ailette de dissipation thermique (2b) ;
une chemise (3) présentant une seconde ailette de dissipation thermique (3b) et formant un récipient de refroidissement conjointement avec le dissipateur thermique (2) ; et
un organe de séparation (4, 4A, 4B, 4C, 4D) disposé entre la première ailette de dissipation thermique (2b) et la seconde ailette de dissipation thermique (3b) qui sont disposées face à face dans le récipient de refroidissement, dans lequel
le récipient de refroidissement présente séparément, dans une paire de surfaces de paroi latérale (1c, 1d) de celui-ci face à face, un orifice d'écoulement entrant (31) et un orifice d'écoulement sortant (32) pour un liquide de refroidissement et présente une voie d'écoulement d'entrée (7a, 7b, 7c) et une voie d'écoulement de sortie (8, 8a, 8b) qui sont disposées parallèlement l'une à l'autre le long d'une autre paire de surfaces de paroi latérale (1a, 1b), du récipient de refroidissement, face à face,
l'organe de séparation (4, 4A, 4B, 4C, 4D) présente
une paire de portions de feuille (41, 41A, 41B, 42, 42A, 42B) qui sont respectivement en contact avec la première ailette de dissipation thermique (2b) et la seconde ailette de dissipation thermique (3b), et
une paroi de séparation (43, 43a, 43b, 43A, 43B, 43C, 43D, 44) couplant la paire de portions de feuille (41, 41A, 41B, 42, 42A, 42B),
deux couches de régions de dissipation thermique (11, 11a, 11b, 11c, 11d) sont formées respectivement par l'une des portions de feuille (41, 41A, 41B) et la première ailette de dissipation thermique (2b), et l'autre portion de feuille (42, 42A, 42B) et la seconde ailette de dissipation thermique (3b),
une région collectrice d'entrée (6, 6a, 6b) et une région collectrice de sortie (9, 9a, 9b) sont formées, entre les deux couches de régions de dissipation thermique (11, 11a, 11b, 11c, 11d), par la paire de portions de feuille (41, 41A, 41B, 42, 42A, 42B) et la paroi de séparation (43, 43a, 43b, 43A, 43B, 43C, 43D, 44),
la région collectrice d'entrée (6, 6a, 6b) communique avec l'orifice d'écoulement entrant (31), la région collectrice de sortie (9, 9a, 9b) communique avec l'orifice d'écoulement sortant (32), et les deux couches de régions de dissipation thermique (11, 11a, 11b, 11c, 11d) communiquent avec la région collectrice d'entrée (6, 6a, 6b) via la voie d'écoulement d'entrée (7, 7a, 7b) et communiquent avec la région collectrice de sortie (9, 9a, 9b) via la voie d'écoulement de sortie (8, 8a, 8b), et
si, dans un plan parallèle à une surface de montage pour la première ailette de dissipation thermique (2b), une direction d'écoulement entrant d'un liquide de refroidissement jusqu'à l'orifice d'écoulement entrant (31) est définie en tant qu'une direction Y et une direction perpendiculaire à la direction Y est définie en tant qu'une direction X, l'organe de séparation (4, 4A, 4B, 4C, 4D) guide un liquide de refroidissement, qui s'est écoulé dans la direction Y dans la région collectrice d'entrée (6, 6a, 6b), jusqu'à la voie d'écoulement d'entrée (7, 7a, 7b) tout en déviant une direction d'avancement du liquide de refroidissement par la paroi de séparation (43, 43a, 43b, 43A, 43B, 43C, 43D, 44), et amène le liquide de refroidissement à s'écouler dans la direction X depuis la voie d'écoulement d'entrée (7, 7a, 7b) dans les deux couches des régions de dissipation thermique (11, 11a, 11b, 11c, 11d).

2. Refroidisseur de type à refroidissement par liquide selon la revendication 1, dans lequel, lorsque l'organe de séparation (4, 4A, 4B, 4C, 4D) est vu dans une direction perpendiculaire à des surfaces des portions d'entrée (41, 41A, 41B, 42, 42A, 42B), une forme de la paroi de séparation (43, 43a, 43b, 43A, 43B, 43C, 43D, 44) est linéaire, en zigzag ou incurvée.

3. Refroidisseur de type à refroidissement par liquide selon la revendication 2, dans lequel une aire en coupe transversale de voie d'écoulement de la région collectrice d'entrée (6, 6a, 6b) diminue continuellement ou par paliers depuis le côté orifice d'écoulement entrant (31) vers le côté orifice d'écoulement sortant (32).

4. Refroidisseur de type à refroidissement par liquide selon la revendication 2 ou 3, dans lequel
une surface, du dissipateur thermique (2), à un côté opposé à la première ailette de dissipation thermique (2b) et une surface, de la chemise (3), à un côté opposé à la seconde ailette de dissipation thermique (3b) sont des surfaces de montage sur lesquelles une pluralité d'éléments de génération de chaleur (50) sont agencés en réseau dans la direction Y, et
la forme de la paroi de séparation (43a, 43b) est déterminée de sorte qu'un débit d'un liquide de refroidissement passant à travers des emplacements, dans chaque région de dissipation thermique (11, 11a, 11b, 11c, 11d), qui correspondent à des emplacements auxquels les éléments de génération thermique (50) sont disposés, devienne supérieur à un débit d'un liquide de refroidissement passant à travers des emplacements, dans la région de dissipation thermique (11, 11a, 11b, 11c, 11d), qui ne correspondent pas aux emplacements auxquels les éléments de génération thermique (50) sont disposés.

5. Refroidisseur de type à refroidissement par liquide selon l'une quelconque des revendications 1 à 4, dans lequel
l'organe de séparation (4A, 4B) inclut deux organes présentant chacun une coupe transversale en forme de U, et
la région collectrice d'entrée (6) et la région collectrice de sortie (9) sont formées séparément par les deux organes.

6. Refroidisseur de type à refroidissement par liquide selon l'une quelconque des revendications 1 à 5, le refroidisseur de type à refroidissement par liquide comprenant en outre des feuilles de séparation (21, 33) pour séparer un intérieur du récipient de refroidissement en une pluralité de zones qui sont adjacentes les unes aux autres dans la direction Y, dans lequel
chacune des zones présente la région collectrice d'entrée (6a, 6b), la voie d'écoulement d'entrée (7a, 7b), les régions de dissipation thermique (11c, 11d), la voie d'écoulement de sortie (8a, 8b), et la région collectrice de sortie (9a, 9b), et
la feuille de séparation (33) présente une ouverture (33a) qui permet une communication entre : la région collectrice de sortie (9a) dans une zone qui est plus proche de l'orifice d'écoulement entrant (31), entre deux des zones qui sont adjacentes l'une à l'autre ; et la région collectrice d'entrée (6b) dans une zone qui est plus éloignée de l'orifice d'écoulement entrant (31), entre les deux zones.

7. Refroidisseur de type à refroidissement par liquide selon l'une quelconque des revendications 1 à 6, dans lequel
dans l'organe de séparation (4), la paroi de séparation (44) est un organe élastique qui présente une élasticité dans la direction perpendiculaire aux surfaces des portions de feuille (41, 42), et
la paire de portions de feuille (41, 42) sont disposées de manière à être en contact étroit avec la première ailette de dissipation thermique (2b) et la seconde ailette de dissipation thermique (3b).

8. Refroidisseur de type à refroidissement par liquide selon la revendication 7, le refroidisseur de type à refroidissement par liquide comprenant en outre, entre la paire de portions de feuille (41, 42), une pluralité de ressorts plats (12) qui supportent des portions de périphérie extérieure des portions de feuille (41, 42).

9. Refroidisseur de type à refroidissement par liquide selon l'une quelconque des revendications 1 à 8, dans lequel, dans l'organe de séparation (4), des matériaux de résine (13) présentant chacun une conductivité thermique inférieure à celle de la paire de portions de feuille (41, 42) sont joints ou collés à des surfaces, des portions de feuille (41, 42), qui sont en contact avec la première ailette de dissipation thermique (2b) et la seconde ailette de dissipation thermique (3b).
